Europäisches Patentamt

European Patent Office

Office européen des brevets

(19)

(11) Publication number: **0 198 320 B1**

# (12) EUROPEAN PATENT SPECIFICATION

(45) Date of publication of patent specification: **29.05.91**

(51) Int. Cl.⁵: **H01L 29/784**, H01L 29/04

(21) Application number: **86104458.4**

(22) Date of filing: **02.04.86**

(54) Thin film transistor using polycrystalline silicon.

(30) Priority: **02.04.85 JP 68478/85**

(43) Date of publication of application:
**22.10.86 Bulletin 86/43**

(45) Publication of the grant of the patent:
**29.05.91 Bulletin 91/22**

(84) Designated Contracting States:
**DE FR GB**

(56) References cited:
**DE-A- 3 317 954**
**GB-A- 2 118 365**

**PROCEEDNGS OF THE 14th CONFERENCE
(1982 INTERNATIONAL) ON SOLID STATE
DEVICES, Tokyo, JAPANESE JOURNAL OF
APPLIED PHYSICS, vol. 22, supplement 22-1,
1983, pages 493-496, Tokyo, JP; Y. OANA et
al.: "Electrical properties of polycrystalline
silicon MOSFETs on glass"**

(73) Proprietor: **HITACHI, LTD.**
**6, Kanda Surugadai 4-chome
Chiyoda-ku, Tokyo 100(JP)**

(72) Inventor: **Hosokawa, Yoshikazu**
**438-8, Kamezaku
Hitachiota-shi(JP)**
Inventor: **Suzuki, Takaya**
**622-5, Ichige
Katsuta-shi(JP)**
Inventor: **Mimura, Akio**
**817-5, Takaba
Katsuta-shi(JP)**
Inventor: **Aoyama, Takashi**
**55-1, Minamidai Tokaimura
Naka-gun Ibaraki-ken(JP)**
Inventor: **Konishi, Nobutake**
**c/o Hitachi Kenkyusho Hitachi Ltd.
4026, Kujicho, Hitachi-shi(JP)**
Inventor: **Miyata, Kenji**
**942-7, Takeda
Katsuta-shi(JP)**

(74) Representative: **Patentanwälte Beetz sen. -
Beetz jun. Timpe - Siegfried - Schmitt-
Fumian
Steinsdorfstrasse 10
W-8000 München 22(DE)**

**Description**

BACKGROUND OF THE INVENTION

The present invention relates to a thin film field effect transistor using polycrystalline silicon, and more particularly to a thin film transistor suitable for driving a liquid crystal display.

A thin film transistor is fabricated in such a manner that a thin semiconductor film is grown on the surface of an insulating substrate and then a transistor is formed in the thin semiconductor film. The thin semiconductor film can be made of various materials such as amorphous silicon, amorphous compound semiconductors and polycrystalline silicon. A thin film transistor made of polycrystalline silicon is high in field-effect mobility, and hence is suited for driving a liquid crystal display, as described in an article entitled "4.25-in. and 1.51-in. B/W and Full-Color LC Video Displays Addressed by Poly-Si TFTs" (SID 84 DIGEST, pages 316 through 319). A further conventional thin film transistor is also known from GB-A-2 118 365.

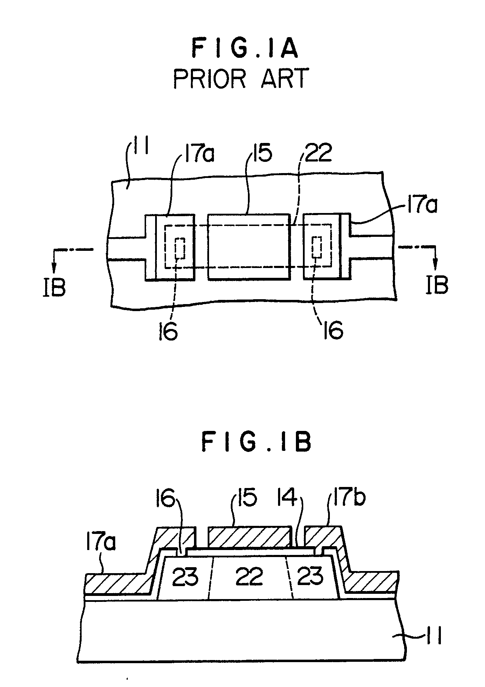

Fig. 1A is a plan view showing a conventional thin film transistor made of polycrystalline silicon, and Fig. 1B is a sectional view taken along the line A-A of Fig. 1A. Referring to Figs. 1A and 1B, a polycrystalline silicon region 22 having the form of an island (namely, a polycrystalline silicon island) is formed on an insulating substrate 11, and highly-doped regions 23 for electrode contact are formed at portions of the polycrystalline silicon region 22.

A gate electrode 15 made of polycrystalline silicon is formed on the surface of the polycrystalline silicon region 22 with a gate insulating film 14 such as a silicon oxide film being interposed therebetween, and a source electrode 17a and a drain electrode 17b each made of aluminum are formed on the highly-doped regions 23 which contains a donor or acceptor at a high concentration level, through openings 16 of the gate insulating film 14. Incidentally, the gate insulating film 14 is omitted from Fig. 1A for the sake of brevity.

When a voltage of desired polarity is applied to the gate electrode 15, a channel is formed in the surface of the polycrystalline silicon region 22 by the applied voltage, and thus the thin film transistor (hereinafter simply referred to as "TFT") is driven into an ON-state. When the electric potential of the gate electrode 15 is made equal to zero, the TFT is brought in an OFF-state.

The resistance of the TFT in the OFF-state is determined by the resistance of the polycrystalline silicon region 22 itself, and others. In general, it is desirable to make large the resistance of the TFT in the OFF-state. The resistance of the polycrystalline silicon region 22 itself can be increased by making small the thickness of the polycrystalline silicon region 22. Usually, a polycrystalline silicon film is grown on an amorphous, insulating substrate. Accordingly, a very small amount of crystal is contained in the film when the thickness of the film is small and a crystal grows and the amount of crystal contained in the film increases, with the increase in the film thickness.

While, the field-effect mobility of the TFT formed of a polycrystalline silicon film has a tendency to increase as the amount of crystal contained in the film is increased. Accordingly, when the thickness of the polycrystalline silicon film is small, the amount of crystal contained in the film decreases, and the field-effect mobility of the TFT is small. Thus, it is impossible to sufficiently reduce the ON-resistance of the TFT (that is, the resistance of the TFT in the ON-state) and to cause a large current to flow through the TFT.

Therefore, in the prior art, the thickness of the polycrystalline silicon film cannot be made small, and thus it is impossible to make sufficiently large the resistance of the TFT in the OFF-state.

Further, the OFF-resistance of the TFT (that is, the resistance of the TFT in the OFF-state) is reduced by the following phenomenon. That is, electric charge is accumulated in the vicinity of the boundary between the insulating substrate 11 and the bottom surface of the polycrystalline silicon region 22, and a parasitic channel is formed in this bottom surface. A current can flow through the parasitic channel, and thus the OFF-resistance of the TFT can be reduced.

In view of the reduction of the field-effect mobility of TFT with the decrease in the film thickness, the thickness of the polycrystalline silicon film is usually selected in a range from 0.5 to 1.0 $\mu$m, as shown in Fig. 9 of an article entitled "Thin-film transistors on molecular-beam-deposited polycrystalline silicon" (J. Appl. Phys., Vol. 55, No. 6, 15 March, 1984, pages 1590 through 1595).

SUMMARY OF THE INVENTION

An object of the present invention is to provide a thin film transistor which can solve the problems of the prior art and has a very high OFF-resistance and an extremely low ON-resistance.

In order to attain the above object, according to the present invention, a thin polycrystalline silicon film transistor is provided as defined in claim 1.

## BRIEF DESCRIPTION OF THE DRAWINGS

Fig. 1A is a plan view showing a conventional TFT.
Fig. 1B is a sectional view taken along the line A-A of Fig. 1A.
Fig. 2A is a plan view showing an embodiment of a TFT according to the present invention.
Fig. 2B is a sectional view taken along the line B-B of Fig. 2A.
Fig. 3 is a longitudinal sectional view showing another embodiment of a TFT according to the present invention.

## DESCRIPTION OF THE PREFERRED EMBODIMENTS

A TFT according to the present invention will be explained below in detail, on the basis of depicted embodiments thereof. The same reference numerals designate like parts throughout the drawings.

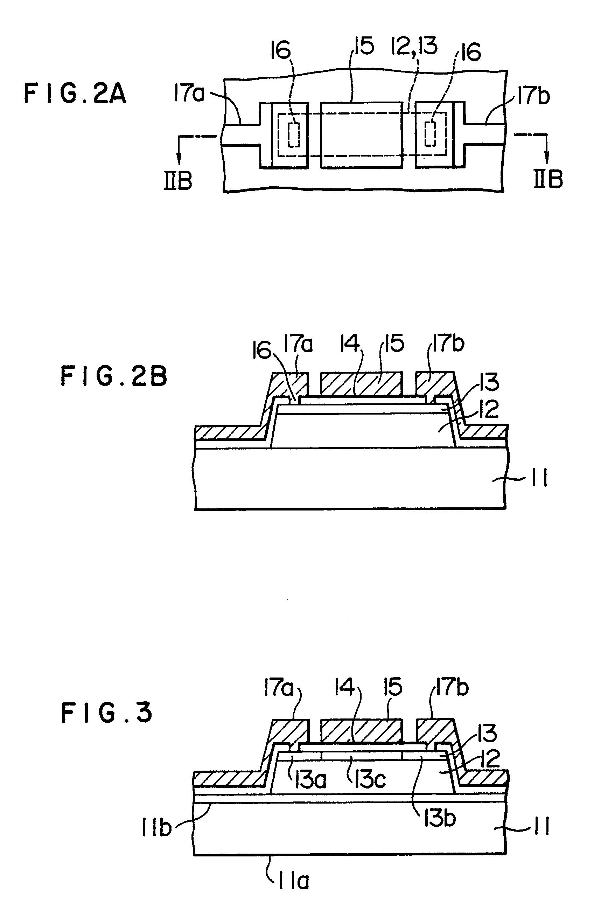

Fig. 2A is a plan view of an embodiment of a TFT according to the present embodiment, and Fig. 2B is a sectional view taken along the line B-B of Fig. 2A. Referring to Figs. 2A and 2B, a polycrystalline silicon island which is a laminate including a high-resistance polycrystalline silicon layer 12 and a low-resistance polycrystalline silicon layer 13, is formed on the insulating substrate 11, and the gate electrode 15 made of polycrystalline silicon is formed on the polycrystalline silicon island, with the gate insulating film 14 being interposed therebetween. The source electrode 17a and the drain electrode 17b each made of aluminum are kept in low resistance contact with the silicon layer 13 through the openings 16 of the gate insulating film 14. The low-resistance contact between the electrodes 17a and 17b and the silicon layer 13 may be made by doping the silicon layer 13 with an n-type or p-type impurity at high impurity concentration as in the conventional TFT of Figs. 1A and 1B, or may be made by other methods.

It has been known that the resistivity of a polycrystalline silicon layer doped with oxygen, nitrogen, or carbon is usually $10^2$ to $10^4$ times greater than the resistivity of a polycrystalline silicon layer which is not doped with the above elements. The high-resistance silicon layer 12 is formed of a polycrystalline silicon layer which is doped with oxygen, nitrogen, or carbon and has a thickness of 0.1 to 1.0 $\mu$m, and the low-resistance silicon layer 13 is formed of a polycrystalline silicon layer which is not doped with oxygen, nitrogen or carbon and has a thickness of 0.01 to 0.3 $\mu$m. Incidentally, the term "high-resistance silicon layer 12" and the term "low-resistance silicon layer 13" merely indicate that the resistance of the silicon layer 12 is larger than that of the silicon layer 13.

Now, let us consider a case where a non-doped polycrystalline silicon film is grown on an amorphous, insulating substrate without any intervening layer therebetween, the silicon film is affected by the amorphous substrate at the initial stage of growth, and silicon crystals are hard to grow. The grown silicon film becomes a polycrystalline silicon film which contains a larger area of amorphous grain boundaries. When another silicon film is deposited on the above silicon film, the greater part of the former film is grown on the amorphous grains of the latter film, and the crystalline region of the former film are not readily enlarged.

In a case where a silicon layer doped with oxygen or the like is grown on the amorphous, insulating substrate, the grown silicon layer is divided into a crystalline silicon region and an amorphous silicon region containing oxygen or the like. When a non-doped silicon layer is deposited on the oxygen-doped silicon layer, the crystallization of the non-doped silicon layer starts from the crystalline region of the underlying silicon layer. With the growth of the non-doped silicon layer, the crystalline region of the non-doped silicon layer is enlarged, and the amorphous region thereof becomes small in area.

Accordingly, even when the high-resistance silicon layer 12 has only a thickness of the order of 0.1 $\mu$m, if it is divided into crystalline regions and amorphous regions having no crystallinity, the low-resistance silicon layer 13 formed thereon, even if it is relatively small in thickness of the order of 0.01 to 0.3 $\mu$m, will have a large degree of crystal content, and a large field-effect mobility. According to the inventors' experiments, it is preferred to select the thickness of the silicon layer 12 in a range from about 0.1 to about 1.0 $\mu$m, since a crystalline nucleus can be readily formed within the above thickness range. Preferably, the thickness of the silicon layer 13 is selected within a range from about 0.01 to about 0.3 $\mu$m, since the silicon layer 13 is excellent in crystallinity and can provide a TFT having a large field effect mobility, within the above thickness range.

The OFF-resistance of a MOS transistor formed on a polycrystalline silicon layer depends upon not only the shape of channel region (which is determined by the channel length and the channel width) but also the resistivity and thickness of the silicon layer. The OFF-resistance $R_{OFF}$ of a MOS transistor formed on the polycrystalline silicon island having the structure shown in Fig. 2B is given by the following equations:

$$R_{OFF} = \frac{R_1 R_2}{R_1 + R_2} \ , \ R_1 = \rho_1 \frac{L}{Wt_1} \ , \ R_2 = \rho_2 \frac{L}{Wt_2}$$

where $\rho_1$ indicates the resistivity of the high-resistance silicon layer 12, $\rho_2$ the resistivity of the low-resistance silicon layer 13, $t_1$ the thickness of the high-resistance silicon layer 12, $t_2$ the thickness of the low-resistance silicon layer 13, L the channel length, and W the channel width.

As mentioned above, the resistivity $\rho_1$ is far greater than the resistivity $\rho_2$. Accordingly, even when the high-resistance silicon layer 12 is greater in thickness than the low-resistance silicon layer 13, the resistance $R_1$ is far greater than the resistance $R_2$, and thus the OFF-resistance $R_{OFF}$ is not substantially affected by the resistance $R_1$. That is, the OFF-resistance $R_{OFF}$ can be expressed by the following formula:

$$R_{OFF} \approx R_2 = \rho_2 \frac{L}{Wt_2}$$

Thus, the OFF-resistance $R_{OFF}$ can be increased by making small the thickness $t_2$ of the low-resistance silicon layer 13.

While, the insulating substrate 11 is kept in contact with the high-resistance silicon layer 12. The layer 12 has a high threshold voltage and is hard to be inverted. In order to form a channel in the surface of the high-resistance silicon layer 12, it is necessary to apply a voltage more than the high threshold voltage to this surface. Accordingly, even when electric charge is accumulated in the vicinity of the boundary between the substrate 11 and the silicon layer 12, the parasitic channel is not formed in the silicon layer 12, and thus an OFF current is not increased.

As has been explained in the above, the present embodiment can be made low in ON-resistance and high in OFF-resistance.

The present embodiment may be an enhancement type transistor which is put in the OFF-state when the potential difference between the gate and the source is equal to zero. Alternatively, a depletion type transistor may be made of the present embodiment in such a manner that the resistivity of the low-resistance silicon layer 13 is more reduced by doping the silicon layer 13 with an impurity.

In a case where the resistivity of the low-resistance silicon layer 13 is more reduced by doping the layer 13 with an n-type or p-type impurity, to form a modified version of the present embodiment, a current can flow through the silicon layer 13 even when the voltage applied between the gate and the drain is made equal to zero. When a high gate voltage whose polarity depends upon the kind of the impurity, is applied, a depletion layer is formed in the silicon layer 13 by the field effect of the gate voltage. When the depletion layer is extended to the high-resistance silicon layer 12, the so-called pinch-off occurs. Thus, no current can flow through the silicon layer 13, and the modified version is put in the OFF-state.

Further, in the present embodiment, the oxygen, nitrogen, or carbon concentration of the high-resistance silicon layer 12 may be varied in the direction of the thickness thereof. When the above concentration is made high at that portion of the silicon layer 12 which is kept in contact with the substrate, the generation of the parasitic channel is further prevented. When the above concentration is made low in the vicinity of the boundary between the silicon layer 12 and the silicon layer 13, the crystal growth in the silicon layer 13 becomes easy, and thus a TFT having excellent characteristics can be formed.

In a case where the low-resistance silicon layer 13 is doped with an n-type or p-type impurity, when the impurity concentration of the silicon layer 13 is made low in the vicinity of the boundary between the silicon layer 12 and the silicon layer 13, the depletion layer is readily extended, and thus the pinch-off readily occurs. Further, in the above case, if the impurity concentration is made high in the vicinity of the boundary between the silicon layer 13 and the gate insulating film 14, the ON-resistance will be reduced.

Fig. 3 shows another embodiment of a TFT according to the present invention. Referring to Fig. 3, the insulating substrate 11 is formed in such a manner that an insulating film 11b made of silicon oxide or silicon nitride is deposited on a supporting member 11a made of fused quartz or monocrystalline silicon.

4

The high-resistance silicon layer 12 and the low-resistance silicon layer 13 are successively formed on the insulating film 11b. The low-resistance silicon layer 13 is divided into a source region 13a, a drain region 13b, and a channel region 13c. The source region 13a and the drain region 13b are highly doped with a donor or acceptor. The OFF-resistance of the present embodiment is determined mainly by the resistance $R_2$ of the channel region 13c. The low-resistance silicon layer 13 may have one of structures such as $n^+$-i-$n^+$, $p^+$-$\pi$-$p^+$, p-n-p and n-p-n. Further, each of the source electrode 17a and the drain electrode 17b may be made of polycrystalline silicon. In this case, in order to keep the source electrode 17a and the drain electrode 17b in ohmic contact with the source region 13a and the drain region 13b, respectively, it is desirable to highly dope a polycrystalline silicon film for forming the electrodes 17a and 17b with an impurity having the same conductivity type as the donor or acceptor contained in the source region 13a and the drain region 13b.

As has been explained in the foregoing, according to the present invention, the thickness of a polycrystalline silicon layer where the channel of a TFT is formed, can be made small without reducing the field-effect mobility of the polycrystalline silicon layer, and electric charge accumulated at the boundary between the TFT and an insulating substrate does not cause a parasitic channel.

## Claims

1. A thin film transistor using polycrystalline silicon as an active layer comprising:
   an insulating substrate (11);
   a thin polycrystalline silicon film formed on said insulating substrate, characterized in that said thin polycrystalline silicon film includes a high-resistance polycrystalline silicon layer (12) disposed on the insulating substrate and comprising a crystalline region and an amorphous region and a low-resistance,polycrystalline silicon layer (13) formed on said crystalline region of said high-resistance polycrystalline silicon layer;
   comprises a source electrode (17a) and a drain electrode (17b) each kept in ohmic contact with said low-resistance polycrystalline silicon layer; and
   a gate electrode (15) provided in such a manner that a gate insulating film (14) is sandwiched between said gate electrode and said low-resistance polycrystalline silicon layer, said gate electrode being formed between said source electrode and said drain electrode.

2. A thin film transistor according to Claim 1, wherein said high-resistance polycrystalline silicon layer (12) is doped with one element selected from a group consisting of oxygen, nitrogen and carbon.

3. A thin film transistor according to Claim 2, wherein said low-resistance polycrystalline silicon layer (13) is doped with one of an n-type impurity and a p-type impurity.

4. A thin film transistor according to Claim 1, wherein the thickness of said high-resistance polycrystalline silicon layer (12) is made greater than the thickness of said low-resistance polycrystalline silicon layer (13).

5. A thin film transistor according to Claim 4, wherein the thickness of said high-resistance polycrystalline silicon layer (12) lies substantially within a range from 0.1 to 1.0 $\mu$m, and the thickness of said low-resistance polycrystalline silicon layer (13) lies substantially within a range from 0.01 to 0.3 $\mu$m.

6. A thin film transistor according to Claim 3, wherein, in at least one of said high-resistance polycrystalline silicon layer (12) and said low-resistance polycrystalline silicon layer (13), the dopant concentration is varied in the direction of the width of said thin polycrystalline silicon film.

## Revendications

1. Transistor à couche mince utilisant du silicium polycristallin comme couche active, comprenant :
   un substrat isolant (11);
   une pellicule mince de silicium polycristallin formée sur ledit substrat isolant,
   caractérisé en ce que ladite pellicule mince de silicium polycristallin comprend une couche de silicium polycristallin de résistance élevée (12) disposée sur le substrat isolant et comportant une région cristalline et une région amorphe, et une couche de silicium polycristallin de faible résistance (13) formée sur ladite région cristalline de ladite couche de silicium polycristallin de haute résistance; et comprend une électrode de source (17a) et une électrode de drain (17b), maintenues chacune en contact ohmique avec ladite couche de silicium polycristallin de faible résistance; et une électrode de grille (15) prévue de telle sorte qu'une pellicule d'isolant de grille (14) est enserrée entre ladite électrode de grille et ladite couche de silicium polycristallin de faible résistance, ladite électrode de grille étant formée entre ladite électrode de source et ladite électrode de drain.

2. Transistor à couche mince selon la revendication 1, dans lequel ladite couche de silicium polycristallin de résistance élevée (12) est dopée par un élément choisi dans un groupe incluant l'oxygène, l'azote et le carbone.

3. Transistor à couche mince selon la revendication 2, dans lequel ladite couche de silicium polycristallin de faible résistance (13) est dopée avec une impureté de type n ou une impureté de type p.

4. Transistor à couche mince selon la revendication 1, dans lequel l'épaisseur de ladite couche de siliciumpolycristallin de résistance élevée (12) est choisie supérieure à l'épaisseur de ladite couche de silicium polycristallin de faible résistance (13).

5. Transistor à couche mince selon la revendication 4, dans lequel l'épaisseur de ladite couche de silicium polycristallin de résistance élevée (12) est située essentiellement dans une gamme comprise entre 0,1 et 1,0 $\mu$m et l'épaisseur de ladite couche de silicium polycristallin de faible résistance (13) est située essentiellement dans une gamme comprise entre 0,01 et 0,3 $\mu$m.

6. Transistor à couche mince selon la revendication 3, dans lequel, dans l'une au moins desdites couches incluant la couche de silicium polycristallin de résistance élevée (12) et ladite couche de silicium polycristallin de faible résistance (13), la concentration de la substance dopante varie dans le sens de la largeur de ladite pellicule mince de silicium polycristallin.

**Ansprüche**

1. Dünnfilmtransistor mit Verwendung von polykristallinem Silizium als einer aktiven Schicht, der ein isolierendes Substrat (11) und einen auf dem isolierenden Substrat gebildeten polykristallinen Siliziumdünnfilm aufweist,
dadurch **gekennzeichnet,**
daß der polykristalline Siliziumdünnfilm eine polykristalline Hochwiderstands-Siliziumschicht (12), die auf dem isolierenden Substrat angeordnet ist und einen kristallinen Bereich sowie einen amorphen Bereich aufweist, und eine polykristalline Niedrigwiderstands-Siliziumschicht (13) enthält, die auf dem kristallinen Bereich der polykristallinen Hochwiderstands-Siliziumschicht gebildet ist;
eine Quellenelektrode (17a) und eine Senkenelektrode (17b), deren jede in ohmschem Kontakt mit der polykristallinen Niedrigwiderstands-Siliziumschicht gehalten ist; und
eine Gateelektrode (15) aufweist, die derart vorgesehen ist, daß ein Gateisolierfilm (14) zwischen der Gateelektrode und der polykristallinen Niedrigwiderstands-Siliziumschicht laminiert ist, wobei die Gateelektrode zwischen der Quellenelektrode und der Senkenelektrode gebildet ist.

2. Dünnfilmtransistor nach Anspruch 1,
wobei die polykristalline Hochwiderstands-Siliziumschicht (12) mit einem Element dotiert ist, das aus einer aus Sauerstoff, Stickstoff und Kohlenstoff bestehenden Gruppe gewählt ist.

3. Dünnfilmtransistor nach Anspruch 2,
wobei die polykristalline Niedrigwiderstands-Siliziumschicht (13) mit einer von einer n-Typ-Verunreinigung und einer p-Typ-Verunreinigung dotiert ist.

4. Dünnfilmtransistor nach Anspruch 1,
wobei die Dicke der polykristallinen Hochwiderstands-Siliziumschicht (12) größer als die Dicke der polykristallinen Niedrigwiderstands-Siliziumschicht (13) gemacht ist.

5. Dünnfilmtransistor nach Anspruch 4,
   wobei die Dicke der polykristallinen Hochwiderstands-Siliziumschicht (12) im wesentlichen innerhalb eines Bereiches von 0,1 bis 1,0 $\mu$m liegt und die Dicke der polykristallinen Niedrigwiderstands-Siliziumschicht (13) innerhalb eines Bereiches von 0,01 bis 0,3 $\mu$m liegt.

6. Dünnfilmtransistor nach Anspruch 3,
   wobei in wenigstens einer der polykristallinen Hochwiderstands-Siliziumschicht (12) und der polykristallinen Niedrigwiderstands-Siliziumschicht (13) die Dotierstoffkonzentration in der Richtung der Dicke des polykristallinen Siliziumdünnfilms geändert ist.

# F I G . I A
## PRIOR ART

# F I G . I B

FIG.2A

16    15  12,13    16

17a                        17b

IIB                         IIB

FIG.2B

16  17a    14  15    17b

13

12

11

FIG.3

17a    14    15    17b

13

12

13a    13c

11b

13b    11

11a